# FASCICULE DE BREVET EUROPEEN

(11) **EP 2 652 812 B1**
(45) Date de publication et mention de la délivrance du brevet: **23.05.2018**
(21) Numéro de dépôt: 11817388.9
(22) Date de dépôt: 19.12.2011
(51) Int. Cl.: H01L 51/52, C03C 17/36, H01L 51/56

(54) **PROCEDE DE FABRICATION D'UN DISPOSITIF OLED**
HERSTELLUNGSVERFAHREN FÜR EINE OLED-VORRICHTUNG
METHOD FOR MANUFACTURING AN OLED DEVICE

(30) Priorité: 17.12.2010 FR 1060747
(43) Date de publication de la demande: 23.10.2013
(73) Titulaire: Saint-Gobain Glass France, 92400 Courbevoie (FR)
(72) Inventeur: BILAINE, Matthieu, F-75015 Paris (FR); LIENHART, Fabien, San Diego, CA 92108 (US); YEH, Li-Ya, 52511 Geilenkirchen (DE); ALSCHINGER, Matthias, 60200 Compiègne (FR)
(74) Mandataire: Saint-Gobain Recherche
(86) Numéro de dépôt international: PCT/FR2011/053047
(87) Numéro de publication internationale: WO 2012/080684

(56) Documents cités:
- WO-A1-2010/142926
- WO-A2-2008/059185
- WO-A2-2008/096089
- FR-A1- 2 913 146

## Description

L'invention se rapporte au domaine de la fabrication de dispositifs à diode électroluminescente organique, aussi appelés dispositifs « OLED » pour « Organic Light Emitting Diodes » en anglais.

L'OLED comporte un matériau, ou un empilement de matériaux, électroluminescent(s) organique(s), et est encadrée par deux électrodes, l'une des électrodes, dite inférieure, généralement l'anode, étant constituée par celle associée au substrat et l'autre électrode, dite supérieure, généralement la cathode, étant agencée sur le système électroluminescent organique.

L'OLED est un dispositif qui émet de la lumière par électroluminescence en utilisant l'énergie de recombinaison de trous injectés depuis l'anode et d'électrons injectés depuis la cathode.

Il existe différentes configurations d'OLED :
- les dispositifs à émission par l'arrière (« bottom émission » en anglais), c'est-à-dire avec une électrode inférieure (semi) transparente et une électrode supérieure réfléchissante ;
- les dispositifs à émission par l'avant (« top émission » en anglais), c'est-à-dire avec une électrode supérieure (semi) transparente et une électrode inférieure réfléchissante ;
- les dispositifs à émission par l'avant et l'arrière, c'est-à-dire avec à la fois une électrode inférieure (semi) transparente et une électrode supérieure (semi) transparente.

L'invention a trait aux dispositifs OLED à émission par l'arrière et éventuellement aussi par l'avant.

Une OLED trouve généralement son application dans un écran de visualisation ou un dispositif d'éclairage.

Les électrodes inférieures doivent présenter la résistivité la plus faible possible, la transmission optique la plus élevée possible, et être particulièrement lisses : une rugosité RMS d'au plus 2 nm, voire 1 nm est souvent nécessaire.

On peut utiliser comme électrode un empilement de couches minces électro-conducteur, notamment un empilement comprenant au moins une couche d'argent. De tels électrodes pour une diode électroluminescente organique ont déjà été divulguées dans la publication internationale WO 2008/059185 A2 et la publication nationale FR 07 53453. Afin notamment d'éviter l'oxydation de l'argent et d'atténuer ses propriétés de réflexion dans le visible, la ou chaque couche d'argent est généralement insérée dans un empilement de couches. La ou chaque couche mince à base d'argent peut être disposée entre deux couches minces diélectriques à base d'oxyde ou de nitrure (par exemple en SnO₂ ou Si₃N₄). Peuvent être également disposées sous la couche d'argent une couche très fine destinée à favoriser le mouillage et la nucléation de l'argent (par exemple en oxyde de zinc ZnO) et sur la couche d'argent une seconde couche très fine (sacrificielle, par exemple en titane) destinée à protéger la couche d'argent au cas où le dépôt de la couche subséquente est réalisé dans une atmosphère oxydante ou en cas de traitements thermiques conduisant à une migration d'oxygène au sein de l'empilement. Ces couches sont respectivement appelées couche de mouillage et couche de bloqueur. Les empilements peuvent également comprendre plusieurs couches d'argent.

Les couches d'argent présentent la particularité de voir leur résistivité améliorée lorsqu'elles sont dans un état au moins partiellement cristallisé. On cherche généralement à augmenter au maximum le taux de cristallisation de ces couches (la proportion massique ou volumique de matière cristallisée) et la taille des grains cristallins (ou la taille de domaines cohérents de diffraction mesurés par des méthodes de diffraction des rayons X).

Il est notamment connu que les couches d'argent présentant un taux de cristallisation élevé et par conséquent une faible teneur résiduelle en argent amorphe présentent une résistivité plus basse ainsi qu'une transmission dans le visible plus élevée que des couches d'argent majoritairement amorphes. La conductivité électrique de ces couches est ainsi améliorée. L'augmentation de la taille des grains s'accompagne en effet d'une diminution des joints de grains, favorable à la mobilité des porteurs de charge électrique.

Un procédé couramment employé à l'échelle industrielle pour le dépôt de couches minces, sur substrat verrier ou polymère, est le procédé de pulvérisation cathodique assisté par champ magnétique, appelé procédé « magnétron ». Dans ce procédé, un plasma est créé sous un vide poussé au voisinage d'une cible comprenant les éléments chimiques à déposer. Les espèces actives du plasma, en bombardant la cible, arrachent lesdits éléments, qui se déposent sur le substrat en formant la couche mince désirée. Ce procédé est dit « réactif » lorsque la couche est constituée d'un matériau résultant d'une réaction chimique entre les éléments arrachés de la cible et le gaz contenu dans le plasma. L'avantage majeur de ce procédé réside dans la possibilité de déposer sur une même ligne un empilement très complexe de couches en faisant successivement défiler le substrat sous différentes cibles, ce généralement dans un seul et même dispositif.

Lors de la mise en oeuvre industrielle du procédé magnétron, le substrat reste à température ambiante ou subit une élévation de température modérée (moins de 80°C), particulièrement lorsque la vitesse de défilement du substrat est élevée (ce qui est généralement recherché pour des raisons économiques). Ce qui peut paraître un avantage constitue toutefois un inconvénient dans le cas des couches précitées, car les faibles températures impliquées ne permettent généralement pas une croissance cristalline suffisante. C'est le cas tout particulièrement pour des couches minces de faible épaisseur et/ou des couches constituées de matériaux dont le point de fusion est très élevé. Les couches obtenues selon ce procédé sont donc majoritairement voire totalement amorphes ou nano-cristallisées (la taille moyenne des grains cristallins étant inférieure à quelques nanomètres), et des traitements thermiques se révèlent nécessaires pour obtenir le taux de cristallisation souhaité ou la taille de grains désirée, et donc la faible résistivité désirée.

Des traitements thermiques possibles consistent à réchauffer le substrat soit pendant le dépôt, soit à l'issue du dépôt, en sortie de ligne magnétron. La cristallisation est d'autant meilleure et la taille des grains est d'autant plus grande que la température du substrat est proche de la température de fusion du matériau constituant le film mince.

Les couches d'argent déposées sur substrat chaud ou ayant subi un traitement thermique postérieur sont toutefois particulièrement rugueuses, ce qui les rend impropres à une utilisation en tant qu'électrode de dispositif OLED.

L'invention a pour but d'obvier aux inconvénients précités en proposant un procédé capable d'obtenir des empilements électro-conducteurs combinant une faible résistivité et une transmission lumineuse élevée avec une faible rugosité.

A cet effet, un objet de l'invention est un procédé de fabrication d'un dispositif à diode électroluminescente organique comprenant au moins une électrode à base d'un empilement de couches minces électro-conducteur déposé sur un substrat, dans lequel le dépôt dudit empilement comprend les étapes suivantes :
- on dépose sur une face dudit substrat un empilement de couches minces comprenant au moins une couche mince d'argent entre au moins deux couches minces,
- on traite thermiquement la face revêtue à l'aide d'au moins un rayonnement laser émettant dans au moins une longueur d'onde comprise entre 500 et 2000 nm de sorte que la résistance carrée de l'empilement est diminuée d'au moins 5%.

A résistance carrée égale, le procédé selon l'invention permet d'utiliser des couches d'argent moins épaisses, et par conséquent présentant des transmissions lumineuses plus élevées. Inversement, à même épaisseur d'argent, les couches obtenues selon l'invention présentent une plus faible résistivité, tout en restant particulièrement peu rugueuses.

De préférence, l'empilement avant traitement comprend au moins une couche mince absorbant au moins partiellement le rayonnement laser de sorte que l'absorption dudit empilement à au moins une longueur d'onde du rayonnement laser est telle que l'absorption d'un substrat de verre clair de 4 mm d'épaisseur revêtu dudit empilement à ladite au moins une longueur d'onde du rayonnement laser est supérieure ou égale à 10%.

L'absorption d'un substrat revêtu de l'empilement à une longueur d'onde donnée est définie comme étant égale à la valeur de 100% à laquelle sont soustraites la transmission du substrat revêtu à la même longueur d'onde et la réflexion du même substrat revêtu à la même longueur d'onde, du côté de l'empilement.

On entend par verre clair un verre silico-sodo-calcique obtenu par flottage, non revêtu de couches, et présentant une transmission lumineuse de l'ordre de 90%, une réflexion lumineuse de l'ordre de 8% et une transmission énergétique de l'ordre de 83% pour une épaisseur de 4 mm. Les transmissions et réflexions lumineuses et énergétiques sont telles que définies par la norme NF EN 410. Des verres clairs typiques sont par exemple commercialisés sous la dénomination SGG Planilux par la société Saint-Gobain Glass France ou sous la dénomination Planibel Clair par la société AGC Flat Glass Europe.

Le procédé selon l'invention n'est bien évidemment pas limité aux dépôts réalisés sur un substrat de verre clair ou sur un substrat de 4 mm d'épaisseur. Le revêtement peut être déposé sur tout type de substrat, mais l'absorption de l'empilement doit être telle que s'il avait été déposé sur un substrat de verre clair dont l'épaisseur est de 4 mm, l'absorption de ce substrat revêtu de l'empilement serait telle que revendiquée.

Le procédé selon l'invention permet d'apporter une énergie suffisante pour favoriser la cristallisation de la couche mince d'argent, par un mécanisme physico-chimique de croissance cristalline autour de germes déjà présents dans la couche, en restant en phase solide. Le fait de favoriser la cristallisation de la couche d'argent peut notamment se traduire en une disparition des éventuels résidus de phase amorphe et/ou en une augmentation de la taille des domaines cohérents de diffraction et/ou en une diminution de la densité de défauts ponctuels (lacunes, interstitiels) ou de défauts surfaciques ou volumiques tels que les macles.

Le procédé selon l'invention présente l'avantage de ne chauffer que l'empilement électro-conducteur, sans échauffement significatif de la totalité du substrat. Il n'est ainsi plus nécessaire de procéder à un refroidissement lent et contrôlé du substrat avant la découpe ou le stockage du verre. Ce procédé rend également possible l'intégration d'un dispositif de chauffage sur les lignes de production continue existantes, plus particulièrement dans l'espace situé entre la sortie de l'enceinte de dépôt sous vide de la ligne magnétron et le dispositif de stockage du verre par empilage. Il est également possible dans certains cas de réaliser le traitement selon l'invention au sein même de l'enceinte de dépôt sous vide. Enfin, le procédé permet d'employer des substrats en matière organique polymérique.

L'utilisation d'un rayonnement laser présente l'avantage d'obtenir des températures généralement inférieures à 100°C, et même souvent inférieures à 50°C au niveau de la face opposée à la première face du substrat (c'est-à-dire au niveau de la face non revêtue). Cette caractéristique particulièrement avantageuse est due au fait que le coefficient d'échange thermique est très élevé, typiquement supérieur à 400 W/(m².s). La puissance surfacique du rayonnement laser au niveau de l'empilement à traiter est même de préférence supérieure ou égale à 1 kW/cm², notamment 10 voire 20 kW/cm².

Cette très forte densité d'énergie permet d'atteindre au niveau de l'empilement la température souhaitée extrêmement rapidement (en général en un temps inférieur ou égal à 1 seconde) et par conséquent de limiter d'autant la durée du traitement, la chaleur générée n'ayant alors pas le temps de diffuser au sein du substrat. Ainsi, chaque point de l'empilement est de préférence soumis au traitement selon l'invention (et notamment porté à une température supérieure ou égale à 300°C) pour une durée généralement inférieure ou égale à 1 seconde, voire 0,5 seconde. A l'inverse, les lampes infrarouge classiquement utilisées (sans dispositif de focalisation du rayonnement) ne permettant pas d'atteindre ces fortes puissances par unité de surface, le temps de traitement doit être plus long pour atteindre les températures désirées (souvent plusieurs secondes), et le substrat est alors nécessairement porté à des températures élevées par diffusion de la chaleur, ce même si la longueur d'ondes du rayonnement est adaptée pour n'être absorbée que par la couche mince et non par le substrat.

Grâce au très fort coefficient d'échange thermique associé au procédé selon l'invention, la partie du verre située à 0,5 mm de la couche mince ne subit généralement pas de températures supérieures à 100°C. La température de la face du substrat opposée à la face traitée par le au moins un rayonnement laser n'excède de préférence pas 100°C, notamment 50°C et même 30°C pendant le traitement thermique.

L'essentiel de l'énergie apportée est donc « utilisée » par l'empilement afin d'améliorer les caractéristiques de cristallisation de la ou de chaque couche d'argent qu'il contient.

Le procédé selon l'invention peut en outre être amélioré par la présence dans l'empilement avant traitement d'au moins une couche mince absorbant suffisamment le rayonnement laser de sorte que l'absorption à au moins une longueur d'onde du rayonnement laser d'un substrat de verre clair de 4 mm d'épaisseur et revêtu de l'empilement est supérieure ou égale à 10%. L'empilement avant traitement peut comprendre une ou plusieurs de ces couches qui seront qualifiées dans la suite du texte de « couches absorbantes ». L'empilement peut par exemple comprendre une couche absorbante, ou encore deux, ou trois, voire quatre et même cinq ou six couches absorbantes. Quel que soit le nombre de couches absorbantes, l'important est que l'absorption de l'empilement à la longueur d'onde du laser soit telle que revendiquée. La présence d'au moins une couche absorbante contribue à renforcer considérablement l'effet du traitement laser : l'énergie absorbée par la couche absorbante est en effet réémise à proximité de la couche d'argent, augmentant la température locale au niveau de cette couche. L'augmentation résultante de l'efficacité du traitement laser permet alors d'améliorer les propriétés de résistivité de l'empilement final, et/ou d'accélérer le traitement et/ou d'utiliser un laser moins puissant et donc moins coûteux.

Afin de renforcer encore l'efficacité du traitement laser, l'absorption de l'empilement est telle que l'absorption avant traitement laser et à au moins une longueur d'onde du rayonnement laser d'un substrat de verre clair de 4 mm d'épaisseur revêtu de l'empilement est de préférence supérieure ou égale à 12%, voire 13% ou 15%, et même 20% ou 25% ou encore 30%.

Le taux de cristallisation obtenu à l'aide du procédé selon l'invention est de préférence supérieur ou égal à 20% ou 50 %, notamment 70% et même 90%. Ce taux de cristallisation, défini comme étant la masse de matériau cristallisé sur la masse totale de matériau, peut être évalué par diffraction des rayons X en utilisant la méthode de Rietveld. Du fait d'un mécanisme de cristallisation par croissance de grains cristallins à partir de germes ou nuclei, l'augmentation du taux de cristallisation s'accompagne généralement d'une augmentation de la taille des grains cristallisés ou des domaines cohérents de diffraction mesurés par diffraction des rayons X.

L'amélioration des caractéristiques de cristallisation permet également d'augmenter la transmission lumineuse du substrat revêtu, d'au moins 5%, notamment 10% absolus, voire 15% et même 20%, toujours en absolu (il ne s'agit pas d'une augmentation relative). La transmission lumineuse est calculée selon la norme NF EN 410.

De préférence, la résistance carrée de l'empilement est diminuée d'au moins 10%, voire 15% ou même 20% par le traitement thermique. Il s'agit ici d'une diminution relative, par rapport à la valeur de la résistance carrée avant traitement.

Le substrat est de préférence en verre ou en matière organique polymérique. Il est de préférence transparent, incolore (il s'agit alors d'un verre clair ou extra-clair) ou coloré, par exemple en bleu, gris ou bronze. Le verre est de préférence de type silico-sodo-calcique, mais il peut également être en verre de type borosilicate ou alumino-borosilicate. Les matières organiques polymériques préférées sont le polycarbonate, le polyméthacrylate de méthyle, le polyéthylène téréphtalate (PET), le polyéthylène naphtalate (PEN), ou encore les polymères fluorés tels que l'éthylène tétrafluoroéthylène (ETFE). Le substrat présente avantageusement au moins une dimension supérieure ou égale à 1 m, voire 2 m et même 3 m. L'épaisseur du substrat varie généralement entre 0,025 mm et 19 mm, de préférence entre 0,4 et 6 mm, notamment entre 0,7 et 2,1 mm pour un substrat en verre, et de préférence entre 0,025 et 0,4 mm, notamment entre 0,075 et 0,125 mm pour un substrat polymère. Le substrat peut être plan ou bombé, voire flexible.

Le substrat de verre est de préférence du type flotté, c'est-à-dire susceptible d'avoir été obtenu par un procédé consistant à déverser le verre fondu sur un bain d'étain en fusion (bain « float »). Dans ce cas, la couche à traiter peut aussi bien être déposée sur la face « étain » que sur la face « atmosphère » du substrat. On entend par faces « atmosphère » et « étain », les faces du substrat ayant été respectivement en contact avec l'atmosphère régnant dans le bain float et en contact avec l'étain fondu. La face étain contient une faible quantité superficielle d'étain ayant diffusé dans la structure du verre. Il peut également être obtenu par laminage entre deux rouleaux, technique permettant en particulier d'imprimer des motifs à la surface du verre.

L'empilement électro-conducteur, avant ou après traitement thermique, comprend au moins une couche d'argent entre au moins deux couches. Dans l'empilement figure de préférence une couche absorbante. Dans les passages qui suivent, nous décrirons d'abord l'architecture préférée des empilements traités selon l'invention avant d'aborder en détail, le cas échéant, l'emplacement de la ou chaque couche absorbante au sein d'une telle architecture. Sauf avis contraire, les épaisseurs indiquées sont des épaisseurs physiques.

L'empilement électro-conducteur, avant ou après traitement thermique, comprend de préférence, à partir du substrat, un premier revêtement comprenant au moins une première couche diélectrique, au moins une couche d'argent, éventuellement une couche de sur-bloqueur et un deuxième revêtement comprenant au moins une deuxième couche. Notamment lorsque le substrat est en matière organique polymérique, par exemple flexible, ou lorsque le substrat est associé à un intercalaire de feuilletage, les premier et deuxième revêtements servent avantageusement de couche barrière à l'humidité et aux gaz.

De préférence, l'épaisseur physique de la ou de chaque couche d'argent est comprise entre 6 et 20 nm.

La couche de sur-bloqueur est destinée à protéger la couche d'argent pendant le dépôt d'une couche ultérieure (par exemple si cette dernière est déposée sous atmosphère oxydante ou nitrurante) et pendant un éventuel traitement thermique ultérieur.

La couche d'argent peut également être déposée sur et en contact avec une couche de sous-bloqueur. L'empilement peut donc comprendre une couche de sur-bloqueur et/ou une couche de sous-bloqueur encadrant la ou chaque couche d'argent.

Les couches de bloqueur (sous-bloqueur et/ou sur-bloqueur) sont généralement à base d'un métal choisi parmi le nickel, le chrome, le titane, le niobium, ou d'un alliage de ces différents métaux. On peut notamment citer les alliages nickel-titane (notamment ceux comprenant environ 50% en poids de chaque métal) ou les alliages nickel-chrome (notamment ceux comprenant 80% en poids de nickel et 20% en poids de chrome). La couche de sur-bloqueur peut encore être constituée de plusieurs couches superposées, par exemple, en s'éloignant du substrat, de titane puis d'un alliage de nickel (notamment un alliage nickel-chrome) ou l'inverse. Les différents métaux ou alliages cités peuvent également être partiellement oxydés, notamment présenter une sous-stoechiométrie en oxygène (par exemple TiOₓ ou NiCrOₓ).

Ces couches de bloqueur (sous-bloqueur et/ou sur-bloqueur) sont très fines, normalement d'une épaisseur inférieure à 1 nm, pour ne pas affecter la transmission lumineuse de l'empilement, et sont susceptibles d'être partiellement oxydées pendant le traitement thermique selon l'invention. Comme indiqué dans la suite du texte, l'épaisseur d'au moins une couche de bloqueur peut être plus élevée, de manière à constituer une couche absorbante au sens de l'invention. D'une manière générale les couches de bloqueur sont des couches sacrificielles, susceptibles de capter l'oxygène provenant de l'atmosphère ou du substrat, évitant ainsi l'oxydation de la couche d'argent.

La première couche diélectrique est typiquement en oxyde (notamment en oxyde d'étain), ou de préférence en nitrure, notamment en nitrure de silicium. D'une manière générale, le nitrure de silicium peut être dopé, par exemple avec de l'aluminium ou du bore, afin de faciliter son dépôt par les techniques de pulvérisation cathodique. Le taux de dopage (correspondant au pourcentage atomique par rapport à la quantité de silicium) ne dépasse généralement pas 2%. Ces couches diélectriques ont pour fonction de protéger la couche d'argent des agressions chimiques ou mécaniques et influent également sur les propriétés optiques, notamment en réflexion, de l'empilement, grâce à des phénomènes interférentiels.

Le premier revêtement peut comprendre une couche diélectrique, ou plusieurs couches diélectriques, typiquement 2 à 3. Ces couches diélectriques sont de préférence en un matériau choisi parmi le nitrure de silicium, les oxydes de titane, d'étain ou de zinc, ou l'un quelconque de leurs mélanges ou solutions solides, par exemple un oxyde d'étain et de zinc, ou un oxyde de titane et de zinc. L'épaisseur physique de la couche diélectrique, ou l'épaisseur physique globale de l'ensemble des couches diélectriques, est de préférence comprise entre 15 et 60 nm, notamment entre 20 et 50 nm.

Le premier revêtement comprend de préférence, immédiatement sous la couche d'argent ou sous l'éventuelle couche de sous-bloqueur, une couche de mouillage dont la fonction est d'augmenter le mouillage et l'accrochage de la couche d'argent. L'oxyde de zinc, notamment dopé à l'aluminium, s'est révélé particulièrement avantageux à cet égard.

Le premier revêtement peut également contenir, directement sous la couche de mouillage, une couche de lissage, qui est un oxyde mixte partiellement voire totalement amorphe (donc de très faible rugosité), dont la fonction est de favoriser la croissance de la couche de mouillage selon une orientation cristallographique préférentielle, laquelle favorise la cristallisation de l'argent par des phénomènes d'épitaxie. La couche de lissage est de préférence composée d'un oxyde mixte d'au moins deux métaux choisis parmi Sn, Zn, In, Ga, Sb. Un oxyde préféré est l'oxyde d'étain et de zinc dopé à l'antimoine.

Dans le premier revêtement, la couche de mouillage ou l'éventuelle couche de lissage est de préférence déposée directement sur la première couche diélectrique. La première couche diélectrique est de préférence déposée directement sur le substrat. Pour adapter au mieux les propriétés optiques de l'empilement (notamment l'aspect en réflexion), la première couche diélectrique peut alternativement être déposée sur une autre couche en oxyde ou en nitrure, par exemple en oxyde de titane ou en nitrure de silicium.

Au sein du deuxième revêtement, la deuxième couche, qui est de préférence conductrice, peut être déposée directement sur la couche d'argent, ou de préférence sur un sur-bloqueur, ou encore sur d'autres couches en oxyde ou en nitrure, destinées à adapter les propriétés optiques de l'empilement. Par exemple, une couche d'oxyde de zinc, notamment dopé à l'aluminium, ou encore une couche d'oxyde d'étain, ou d'oxyde d'étain et de zinc peut être disposée entre un sur-bloqueur et la deuxième couche. L'oxyde de zinc, notamment dopé à l'aluminium, permet d'améliorer l'adhésion entre l'argent et les couches supérieures.

Ainsi, l'empilement traité selon l'invention comprend de préférence au moins une succession ZnO / Ag / ZnO. L'oxyde de zinc peut être dopé à l'aluminium. Une couche de sous-bloqueur peut être disposée entre la couche d'argent et la couche sous-jacente. Alternativement ou cumulativement, une couche de sur-bloqueur peut être disposée entre la couche d'argent et la couche sus-jacente.

Enfin, le deuxième revêtement peut être surmonté d'une surcouche destinée à protéger l'empilement contre toutes agressions mécaniques (rayures...) ou chimiques. Cette surcouche est généralement très fine pour ne pas perturber l'aspect en réflexion de l'empilement (son épaisseur est typiquement comprise entre 1 et 5 nm). Elle est de préférence à base d'oxyde de titane ou d'oxyde mixte d'étain et de zinc, notamment dopé à l'antimoine, déposé sous forme sous-stoechiométrique. Comme indiqué par la suite, la composition de cette surcouche peut être choisie afin qu'elle soit la ou une couche absorbante de l'empilement.

De préférence, la dernière couche de l'empilement est en un oxyde transparent conducteur présentant un travail de sortie élevé, tel qu'un oxyde d'indium et d'au moins un élément choisi parmi l'étain et le zinc (couches ITO, IZO, ITZO).

L'empilement peut comprendre une ou plusieurs couches d'argent, notamment deux ou trois couches d'argent. Lorsque plusieurs couches d'argent sont présentes, l'architecture générale présentée ci-avant peut être répétée. Dans ce cas, le deuxième revêtement relatif à une couche d'argent donnée (donc situé au-dessus de cette couche d'argent) coïncide généralement avec le premier revêtement relatif à la couche d'argent suivante.

L'empilement avant traitement thermique comprend de préférence au moins une couche absorbante. Une couche mince absorbante peut être située en contact direct de la couche d'argent afin d'améliorer le transfert de l'énergie réémise vers la couche d'argent. Une couche mince absorbante peut notamment être située en-dessous de la couche d'argent (c'est-à-dire plus proche du substrat) et/ou au-dessus de la couche d'argent.

Selon un premier mode de réalisation préféré, une couche mince absorbant au moins partiellement le rayonnement laser est une couche métallique déposée directement au-dessus de la couche d'argent (couche de sur-bloqueur), voire directement sous la couche d'argent (couche de sous-bloqueur), et dont l'épaisseur est comprise entre 2 et 5 nm, notamment entre 3 et 5 nm. Cette couche de bloqueur va s'oxyder partiellement lors du traitement laser, donnant naissance à un oxyde globalement sous-stoechiométrique en oxygène dont l'absorption lumineuse est réduite. Des couches plus fines ne présentent pas l'absorption suffisante pour qu'un effet de transfert de l'énergie vers la couche d'argent soit perceptible. En outre, des couches plus fines ont tendance à s'oxyder totalement lors du traitement laser, entraînant une mauvaise résistance mécanique de l'empilement final. La gamme d'épaisseur décrite, inhabituelle car plus élevée que l'épaisseur typique des couches de bloqueur, est donc particulièrement bien adaptée au traitement selon l'invention. En ce qui concerne la nature chimique des couches de bloqueur, ce qui a été décrit *supra* s'applique également au cas où la couche de bloqueur est une couche absorbante au sens de l'invention.

Selon un deuxième mode de réalisation préféré, une couche mince absorbant au moins partiellement le rayonnement laser est une couche de nitrure, notamment stoechiométrique ou sous-stoechiométrique en azote. Le nitrure stoechiométrique est de préférence le nitrure de titane qui présente une absorption élevée dans la gamme de longueur d'onde du laser. Le nitrure sous-stoechiométrique en azote est de préférence choisi parmi les nitrures sous-stoechiométriques de silicium, d'aluminium, de titane, de niobium, ou l'un quelconque de leurs mélanges. La couche de nitrure absorbante présente de préférence une épaisseur comprise entre 2 et 10 nm, notamment entre 2 et 5 nm.

Selon un troisième mode de réalisation préféré, une couche mince absorbant au moins partiellement le rayonnement laser est une couche constituée d'un métal, d'un oxyde métallique sous-stoechiométrique en oxygène ou d'un nitrure métallique. Dans le cadre de l'architecture générale présentée précédemment, il s'agit de la surcouche. Cette surcouche va généralement s'oxyder lors du traitement laser, si bien que son absorption lumineuse à l'issue du traitement sera très faible. L'épaisseur de cette couche en contact avec l'air est de préférence inférieure ou égale à 5 nm, voire à 3 nm, et supérieure ou égale à 1 nm. Une épaisseur aussi faible est généralement suffisante pour obtenir l'absorption visée. Une faible épaisseur permet en outre une oxydation complète après traitement selon l'invention, et permet donc d'atteindre de fortes transmissions lumineuses. Le métal est de préférence choisi parmi le silicium, le niobium, le titane, l'aluminium, le zinc, l'étain, le nickel, le zirconium, ou l'un quelconque de leurs alliages. L'oxyde sous-stoechiométrique en oxygène est de préférence un oxyde de silicium, de niobium, de titane, d'aluminium, de zinc, d'étain, de zirconium, ou l'un quelconque de leurs mélanges. Le nitrure peut être stoechiométrique, et dans ce cas, il s'agit de préférence d'un nitrure de titane. Le nitrure peut également être sous-stoechiométrique : il peut alors s'agit d'un nitrure de silicium, d'aluminium, de titane, de niobium, de zinc, d'étain, de zirconium, ou l'un quelconque de leurs mélanges.

Selon un quatrième mode de réalisation préféré, une couche mince absorbant au moins partiellement le rayonnement laser est une couche d'un oxyde métallique sous-stoechiométrique en oxygène, située sous et de préférence en contact avec la ou chaque couche d'argent et/ou située sur et de préférence en contact avec la ou chaque couche d'argent. Il peut notamment s'agir d'une couche de mouillage, au sens précédemment défini. L'oxyde sous-stoechiométrique en oxygène est de préférence choisi parmi l'oxyde de zinc, l'oxyde de titane, l'oxyde d'étain ou l'un de leurs mélanges.

Selon un cinquième mode de réalisation préféré, une couche mince absorbant au moins partiellement le rayonnement laser est une couche à base de carbone, en contact avec l'air. Le carbone est de préférence du type graphite ou amorphe, et/ou contient au moins 50%, voire 100% de carbone sp2. La couche mince à base de carbone est de préférence constituée de carbone, mais peut toutefois être dopée avec un métal ou partiellement hydrogénée. L'épaisseur de la couche de carbone est de préférence inférieure à 5 nm, notamment 2 nm et même 1 nm. Le carbone est doté d'une forte capacité d'absorption dans le visible et l'infrarouge. La couche de carbone, surtout lorsqu'il est majoritairement hybridé sp2, notamment du type graphite ou amorphe, et ce d'autant plus que son épaisseur est faible, est éliminée lors du traitement, probablement par oxydation en dioxyde de carbone, lequel s'évapore, si bien que l'absorption résiduelle après traitement est minime. La couche mince à base de carbone peut être obtenue par diverses techniques, notamment la pulvérisation cathodique assistée par champ magnétique, par exemple à l'aide d'une cible de graphite sous atmosphère d'argon. D'autres procédés de dépôt incluent le dépôt chimique en phase vapeur (CVD), le dépôt à l'arc, par évaporation, par des procédés de type sol-gel.

Selon un sixième mode de réalisation préféré, une couche absorbante est une couche d'oxyde d'indium et d'au moins un élément choisi parmi l'étain et le zinc. Cette couche est généralement la dernière couche de l'empilement (la plus éloignée du substrat). Il s'agit notamment d'une couche d'ITO.

Quelle que soit sa position dans l'empilement, la ou une couche absorbante peut également être à base d'un oxyde dopé par au moins un ion d'un métal de transition (par exemple, le fer, le chrome, le vanadium, le manganèse, le cobalt, le nickel, le cuivre) ou d'une terre rare (par exemple le néodyme ou l'europium).

L'empilement traité peut comprendre une seule couche absorbante. Il peut aussi en comprendre plus, par exemple deux, trois, quatre ou cinq, en particulier dans le cas où la présence d'une seule couche absorbante ne suffit pas à atteindre l'absorption visée pour l'empilement global. L'empilement peut donc être choisi de sorte qu'il contienne plusieurs couches absorbantes, qui combinées permettent d'atteindre l'absorption visée, mais qui individuellement ne le permettent pas. C'est en particulier le cas pour les empilements comprenant plus d'une couche d'argent, notamment deux ou trois : la multiplication du nombre de bloqueurs (sous- et/ou sur-bloqueurs) peut conduire à obtenir une forte absorption à la longueur d'onde du laser, alors que chacune des couches présente une épaisseur insuffisante pour aboutir seule à cette absorption.

Pour améliorer encore l'absorption du rayonnement laser par l'empilement, ce dernier peut donc comprendre plusieurs des types de couches absorbantes précédemment décrites. Chacun des modes de réalisation préférés qui viennent d'être décrits peut notamment être combiné avec un ou plusieurs autres modes. On peut en particulier combiner les modes préférés 1 et 2, 1 et 3, 1 et 4, 1 et 5, 1 et 6, 2 et 3, 2 et 4, 3 et 4, 2 et 5, 2 et 6, 3 et 5, 3 et 6, 1,2 et 3, 1,2 et 4, 1, 2 et 5, 1, 2 et 6, 1, 3 et 4, 1, 3 et 5, 1, 3 et 6, 2, 3 et 4, 2, 3, et 5, 2, 3 et 6, 3, 4, et 5, 3, 4 et 6, 4, 5 et 6, 1, 2, 3 et 4, 1, 2, 3 et 5, 1, 2, 3 et 6, 1, 2, 4 et 5, 1, 2, 4 et 6, 1, 3, 4 et 5, 1, 3, 4, 5 et 6, 2, 3, 4 et 5, 2, 3, 4, 5 et 6, 1, 2, 3, 4, 5 et 6. A titre d'exemple, l'empilement peut comprendre une couche de bloqueur épaissie (d'épaisseur comprise entre 2 et 5 nm) et une surcouche absorbante (combinaison des premier et troisième modes de réalisation préférés). Certains modes préférés peuvent également être combinés avec eux-mêmes. Il en est ainsi du deuxième mode préféré, dans le sens où l'empilement peut comprendre plusieurs couches absorbantes de nitrure. De même, l'empilement peut comprendre plusieurs couches de bloqueur (sous-et/ou sur-bloqueurs) épaissies de manière à augmenter leur absorption du rayonnement laser (combinaisons du premier mode).

Quelques exemples non limitatifs d'empilement pouvant être traités selon l'invention son décrits ci-après. Les couches sont indiquées dans l'ordre de dépôt à partir du substrat.
Empilement 1 : Si₃N₄ / SnZnOₓ / ZnO / Ag / Ti / ITO
Empilement 2 : Si₃N₄ / SnZnOₓ / ZnO / Ag / Ti / ZnO / SnZnOₓ / ZnO / Ag / Ti / ITO

Dans le cas de l'empilement 1, une couche absorbante est constituée par le sur-bloqueur (ici en titane, mais les métaux ou alliages cités précédemment peuvent être utilisés) lorsqu'il est épaissi ainsi que par la couche d'ITO. Cet empilement illustre donc les premier et sixième modes préférés.

L'empilement 2 illustre un empilement à deux couches d'argent.

Dans les empilements présentés ci-avant, au moins une couche d'oxyde de zinc peut également être sous-stoechiométrique en oxygène et constituer une couche absorbante illustrant le quatrième mode préféré.

La rugosité RMS de l'empilement est de préférence d'au plus 2 nm, notamment 1 nm, aussi bien avant qu'après traitement.

Le traitement selon l'invention est généralement réalisé à l'aide d'un rayonnement présentant une longueur d'onde bien définie. Néanmoins, l'invention n'exclut pas d'utiliser plusieurs lasers différents de sorte que le substrat revêtu subit l'action de plusieurs rayonnements de longueurs d'onde différentes.

La longueur d'onde du rayonnement est de préférence comprise entre 530 et 1000 nm, ou entre 600 et 1000 nm, notamment entre 700 et 990 nm, voire entre 800 et 990 nm car l'argent réfléchit moins ce type de rayonnement que les rayonnements infrarouge de longueur d'onde plus élevée. Le traitement est alors plus efficace. En outre, le substrat, s'il est en verre clair, absorbe moins dans cette gamme de longueur d'onde. Il est alors moins à même de subir des températures élevées.

On utilise de préférence des diodes laser, émettant par exemple à une longueur d'onde de l'ordre de 808 nm, 880 nm, 915 ou encore 940 nm ou 980 nm. Sous forme de systèmes de diodes, de très fortes puissances peuvent être obtenues, permettant d'atteindre des puissances surfaciques au niveau de l'empilement à traiter supérieures à 1kW/cm², voire à 10 ou même 20 kW/cm².

Pour une simplicité de mise en oeuvre accrue, les lasers employés dans le cadre de l'invention peuvent être fibrés, ce qui signifie que le rayonnement laser est injecté dans une fibre optique puis délivré près de la surface à traiter par une tête de focalisation. Le laser peut également être à fibre, au sens où le milieu d'amplification est lui-même une fibre optique.

Le faisceau laser peut être ponctuel, auquel cas il est nécessaire de prévoir un système de déplacement du faisceau laser dans le plan du substrat.

De préférence toutefois, le rayonnement laser est issu d'au moins un faisceau laser formant une ligne (appelée « ligne laser » dans la suite du texte) qui irradie simultanément toute ou partie de la largeur du substrat. Ce mode est préféré car il évite l'utilisation de systèmes de déplacement coûteux, généralement encombrants, et d'entretien délicat. Le faisceau laser en ligne peut notamment être obtenu à l'aide de systèmes de diodes laser de forte puissance associées à une optique de focalisation. L'épaisseur de la ligne est de préférence comprise entre 0,01 et 1 mm. La longueur de la ligne est typiquement comprise entre 5 mm et 1 m. Le profil de la ligne peut notamment être une courbe de Gauss ou un créneau.

La ligne laser irradiant simultanément toute ou partie de la largeur du substrat peut être composée d'une seule ligne (irradiant alors toute la largeur du substrat), ou de plusieurs lignes, éventuellement disjointes. Lorsque plusieurs lignes sont utilisées, il est préférable qu'elles soient disposées de sorte que toute la surface de l'empilement soit traitée. La ou chaque ligne est de préférence disposée perpendiculairement à la direction de défilement du substrat, ou disposée de manière oblique. Les différentes lignes peuvent traiter le substrat simultanément, ou de manière décalée dans le temps. L'important est que toute la surface à traiter le soit.

Afin de traiter toute la surface de la couche, on met de préférence en oeuvre un déplacement relatif entre d'une part le substrat revêtu de la couche et la ou chaque ligne laser. Le substrat peut ainsi être mis en déplacement, notamment en défilement en translation en regard de la ligne laser fixe, généralement en dessous, mais éventuellement au-dessus de la ligne laser. Ce mode de réalisation est particulièrement appréciable pour un traitement en continu. Alternativement, le substrat peut être fixe et le laser peut être mobile. De préférence, la différence entre les vitesses respectives du substrat et du laser est supérieure ou égale à 1 mètre par minute, voire 4 et même 6, 8, 10 ou 15 mètres par minute, ce afin d'assurer une grande vitesse de traitement. Le choix judicieux, selon l'invention, de certaines couches de l'empilement permet d'assurer une très forte diminution de la résistivité pour de grandes vitesses de déplacement, et donc de grandes vitesses de traitement.

Lorsque le substrat est en déplacement, notamment en translation, il peut être mis en mouvement à l'aide de tous moyens mécaniques de convoyage, par exemple à l'aide de bandes, de rouleaux, de plateaux en translation. Le système de convoyage permet de contrôler et réguler la vitesse du déplacement. Si le substrat en matière organique polymérique souple, le déplacement peut être réalisé à l'aide d'un système d'avance de films sous forme d'une succession de rouleaux.

Le laser peut également être mis en mouvement de manière à ajuster sa distance au substrat, ce qui peut être utile en particulier lorsque le substrat est bombé, mais pas seulement. En effet, il est préférable que le faisceau laser soit focalisé sur le revêtement à traiter de sorte que ce dernier soit situé à une distance inférieure ou égale à 1 mm du plan focal. Si le système de déplacement du substrat ou du laser n'est pas suffisamment précis quant à la distance entre le substrat et le plan focal, il convient de préférence de pouvoir ajuster la distance entre le laser et le substrat. Cet ajustement peut être automatique, notamment régulé grâce à une mesure de la distance en amont du traitement.

Lorsque la ligne laser est en déplacement, il faut prévoir un système de déplacement du laser, situé au-dessus ou en dessous du substrat. La durée du traitement est régulée par la vitesse de déplacement de la ligne laser.

Toutes les positions relatives du substrat et du laser sont bien entendu possibles, du moment que la surface du substrat peut être convenablement irradiée. Le substrat sera le plus généralement disposé de manière horizontale, mais il peut aussi être disposé verticalement, ou selon toute inclinaison possible. Lorsque le substrat est disposé horizontalement, le laser est généralement disposé de manière à irradier la face supérieure du substrat. Le laser peut également irradier la face inférieure du substrat. Dans ce cas, il faut que le système de support du substrat, éventuellement le système de convoyage du substrat lorsque ce dernier est en mouvement, laisse passer le rayonnement dans la zone à irradier. C'est le cas par exemple lorsque l'on utilise des rouleaux de convoyage : les rouleaux étant disjoints, il est possible de disposer le laser dans une zone située entre deux rouleaux successifs.

Lorsque les deux faces du substrat sont à traiter, il est possible d'employer plusieurs lasers situés de part et d'autre du substrat, que ce dernier soit en position horizontale, verticale, ou selon toute inclinaison.

Le dispositif de rayonnement, par exemple le laser en ligne, peut être intégré dans une ligne de dépôt de couches, par exemple une ligne de dépôt par pulvérisation cathodique assistée par champ magnétique (procédé magnétron), ou une ligne de dépôt chimique en phase vapeur (CVD), notamment assistée par plasma (PECVD), sous vide ou sous pression atmosphérique (APPECVD). La ligne comprend en général des dispositifs de manutention des substrats, une installation de dépôt, des dispositifs de contrôle optique, des dispositifs d'empilage. Les substrats défilent, par exemple sur des rouleaux convoyeurs, successivement devant chaque dispositif ou chaque installation.

Le dispositif de rayonnement, par exemple le laser en ligne, est de préférence situé juste après l'installation de dépôt de la couche, par exemple à la sortie de l'installation de dépôt. Le substrat revêtu peut ainsi être traité en ligne après le dépôt de la couche, à la sortie de l'installation de dépôt et avant les dispositifs de contrôle optique, ou après les dispositifs de contrôle optique et avant les dispositifs d'empilage des substrats.

Le dispositif de rayonnement peut aussi être intégré à l'installation de dépôt. Par exemple, le laser peut être introduit dans une des chambres d'une installation de dépôt par pulvérisation cathodique, notamment dans une chambre où l'atmosphère est raréfiée, notamment sous une pression comprise entre 10⁻⁶ mbar et 10⁻² mbar. Le laser peut aussi être disposé en dehors de l'installation de dépôt, mais de manière à traiter un substrat situé à l'intérieur de ladite installation. Il suffit de prévoir à cet effet un hublot transparent à la longueur d'ondes du rayonnement utilisé, au travers duquel le rayon laser viendrait traiter la couche. Il est ainsi possible de traiter une couche (par exemple une couche d'argent) avant le dépôt subséquent d'une autre couche dans la même installation. Lorsqu'une couche absorbante est une surcouche, par exemple métallique, son oxydation lors du traitement peut être gênée dans le cas où le substrat est placé dans une chambre sous vide. Il est possible dans ce cas de traiter l'empilement dans une chambre spéciale, dans laquelle on contrôlerait l'atmosphère oxydante.

Que le dispositif de rayonnement soit en dehors de ou intégré à l'installation de dépôt, ces procédés « en ligne » sont préférables à un procédé en reprise dans lequel il serait nécessaire d'empiler les substrats de verre entre l'étape de dépôt et le traitement thermique.

Les procédés en reprise peuvent toutefois avoir un intérêt dans les cas où la mise en oeuvre du traitement thermique selon l'invention est faite dans un lieu différent de celui où est réalisé le dépôt, par exemple dans un lieu où est réalisée la transformation du verre. Le dispositif de rayonnement peut donc être intégré à d'autres lignes que la ligne de dépôt de couches. Il peut par exemple être intégré à une ligne de fabrication de vitrages multiples (doubles ou triples vitrages notamment), ou à une ligne de fabrication de vitrages feuilletés. Dans ces différents cas, le traitement thermique selon l'invention est de préférence réalisé avant la réalisation du vitrage multiple ou feuilleté.

Le dépôt de l'empilement sur le substrat peut être réalisé par tout type de procédé, en particulier des procédés générant des couches majoritairement amorphes ou nano-cristallisées, tels que le procédé de pulvérisation cathodique, notamment assisté par champ magnétique (procédé magnétron), le procédé de dépôt chimique en phase vapeur assisté par plasma (PECVD), le procédé d'évaporation sous vide, ou le procédé sol-gel.

L'empilement est de préférence déposé par pulvérisation cathodique, notamment assistée par champ magnétique (procédé magnétron).

Pour plus de simplicité, le traitement laser de la couche se fait de préférence sous air et/ou à pression atmosphérique. Il est toutefois possible de procéder au traitement thermique de la couche au sein même de l'enceinte de dépôt sous vide, par exemple avant un dépôt subséquent.

Le traitement laser est de préférence tel que l'on porte chaque point de la couche mince à une température d'au moins 300°C en maintenant une température inférieure ou égale à 100°C en tout point de la face dudit substrat opposée à ladite première face, de manière à augmenter le taux de cristallisation de ladite couche mince en la conservant continue et sans étape de fusion de ladite couche mince. La couche mince reste donc continue à l'issue du traitement.

Par « couche mince continue », on entend au sens de la présente invention que la couche recouvre sensiblement la totalité du substrat ou, dans le cas d'un empilement, la totalité de la couche sous-jacente. Il est important que le caractère continu de la couche mince (et donc ses propriétés avantageuses) soit préservé par le traitement selon l'invention.

Par « point de la couche », on entend une zone de la couche subissant le traitement à un instant donné. Selon l'invention, la totalité de la couche (donc chaque point) est portée à une température d'au moins 300°C, mais chaque point de la couche n'est pas nécessairement traité simultanément. La couche peut être traitée au même instant dans son ensemble, chaque point de la couche étant simultanément porté à une température d'au moins 300°C. La couche peut alternativement être traitée de manière à ce que les différents points de la couche ou des ensembles de points soient successivement portés à une température d'au moins 300°C, ce deuxième mode étant plus souvent employé dans le cas d'une mise en oeuvre continue à l'échelle industrielle.

Le procédé selon l'invention peut être mis en oeuvre sur un substrat placé aussi bien horizontalement que verticalement. Il peut également être mis en oeuvre sur un substrat pourvu de couches minces sur ses deux faces, au moins une couche d'une des faces ou de chaque face étant traitée selon l'invention. Dans le cas où des couches minces déposées sur les deux faces du substrat sont traitées selon l'invention, il est possible de traiter lesdites couches minces de chaque face soit simultanément, soit successivement, par des techniques identiques ou distinctes, en particulier selon que la nature des couches traitées est identique ou distincte. Le cas où le traitement selon l'invention est réalisé simultanément sur les deux faces du substrat est donc bien compris dans la portée de l'invention.

Un autre objet de l'invention est un dispositif à diode électroluminescente organique susceptible d'être obtenu par un procédé selon l'invention.

L'invention est illustrée à l'aide des exemples de réalisation non limitatifs qui suivent.

### EXEMPLE 1

Sur un substrat en verre de 1,6 mm d'épaisseur commercialisé sous la dénomination SGG Planilux par la demanderesse est déposé par pulvérisation cathodique un empilement à base d'argent servant d'électrode pour composant électroluminescent organique.

Les couches constituant l'empilement ainsi que leurs épaisseurs géométriques respectives sont indiquées dans le tableau 1 ci-après. La première couche du tableau est la première couche déposée sur le substrat.

**Tableau 1**

| Couche | Epaisseur (nm) |
|---|---|
| Si₃N₄ | 30 |
| SnZnOx | 5 |
| ZnO | 5 |
| Ag | 8,75 |
| Ti | <1 |
| ZnO | 5 |
| SnZnOx | 60 |
| ZnO | 5 |
| Ag | 8,75 |
| Ti | <1 |
| ITO | 20 |

La résistance carrée de l'empilement avant traitement est de 2,45 Ohms.

Le substrat revêtu de son empilement est ensuite traité à l'aide d'un laser en ligne émettant un rayonnement d'une longueur d'onde de 980 nm, en regard duquel le substrat revêtu vient défiler en translation avec une vitesse de 8 mètres par minute. La densité de puissance de la ligne laser est de 40 kW/cm². La résistance carrée après traitement est de 2,33 Ohms, soit une baisse de 5%. La rugosité RMS de l'empilement reste inférieure à 1 nm après traitement.

### EXEMPLE 2

Sur un substrat en verre de 0,7 mm d'épaisseur est déposé par pulvérisation cathodique un empilement à base d'argent servant d'électrode pour composant électroluminescent organique du même type que celui de l'exemple 1.

La résistance carrée de l'empilement avant traitement est de 3,3 Ohms.

Le substrat revêtu de son empilement est ensuite traité à l'aide d'un laser en ligne émettant un rayonnement d'une longueur d'onde de 980 nm ayant une densité de puissance de 50 kW/cm², en regard duquel le substrat revêtu vient défiler en translation avec une vitesse de 13 mètres par minute. La résistance carrée après traitement est de 2,43 Ohms, soit une baisse de 24,5%.

La rugosité RMS de l'empilement reste inférieure à 1 nm après traitement.

### EXEMPLE 3

Sur un substrat en verre de 2,1 mm d'épaisseur commercialisé sous la dénomination SGG Planilux par la demanderesse est déposé par pulvérisation cathodique un empilement à base d'argent servant d'électrode pour composant électroluminescent organique du même type que celui de l'exemple 1.

La résistance carrée de l'empilement avant traitement est de 4,87 Ohms.

Le substrat revêtu de son empilement est ensuite traité à l'aide d'un laser en ligne émettant un rayonnement d'une longueur d'onde de 980 nm, en regard duquel le substrat revêtu vient défiler en translation avec une vitesse de 19 mètres par minute. La densité de puissance de la ligne laser est de 50 kW/cm². La résistance carrée après traitement est de 3,95 Ohms, soit une baisse de 19%.

La rugosité RMS de l'empilement reste inférieure à 1 nm après traitement.

## Revendications

1. Procédé de fabrication d'un dispositif à diode électroluminescente organique comprenant au moins une électrode à base d'un empilement de couches minces électro-conducteur déposé sur un substrat, dans lequel le dépôt dudit empilement comprend les étapes suivantes :
- on dépose sur une face dudit substrat un empilement de couches minces comprenant au moins une couche mince d'argent entre au moins deux couches minces,
- on traite thermiquement la face revêtue à l'aide d'au moins un rayonnement laser émettant dans au moins une longueur d'onde comprise entre 500 et 2000 nm de sorte que la résistance carrée de l'empilement est diminuée d'au moins 5%.

2. Procédé selon la revendication 1, tel que ledit empilement avant traitement comprend au moins une couche mince absorbant au moins partiellement le rayonnement laser de sorte que l'absorption dudit empilement à au moins une longueur d'onde du rayonnement laser est telle que l'absorption d'un substrat de verre clair de 4 mm d'épaisseur revêtu dudit empilement à ladite au moins une longueur d'onde du rayonnement laser est supérieure ou égale à 10%.

3. Procédé selon l'une des revendications précédentes, tel que la température de la face du substrat opposée à la face traitée par le au moins un rayonnement laser n'excède pas 100°C, notamment 50°C et même 30°C pendant le traitement thermique.

4. Procédé selon l'une des revendications précédentes, tel que la résistance carrée de l'empilement est diminuée d'au moins 15% ou 20% par le traitement thermique.

5. Procédé selon l'une des revendications précédentes, tel que le substrat est en verre ou en matière organique polymérique.

6. Procédé selon la revendication précédente, tel que le substrat est en polyéthylène téréphtalate ou en polyéthylène naphtalate.

7. Procédé selon l'une des revendications 2 à 6, tel qu'une couche mince absorbant au moins partiellement le rayonnement laser est une couche métallique déposée directement au-dessus de la couche d'argent ou directement en-dessous de la couche d'argent et dont l'épaisseur est comprise entre 2 et 5 nm, notamment entre 3 et 5 nm, couche métallique notamment choisie parmi les couches à base de titane, nickel, chrome, niobium, ou l'un quelconque de leurs alliages.

8. Procédé selon l'une des revendications 2 à 7, tel qu'une couche mince absorbant au moins partiellement le rayonnement laser est une couche de nitrure, notamment choisi parmi le nitrure stoechiométrique de titane ou les nitrures, sous-stoechiométriques en azote, de silicium, d'aluminium, de niobium, de titane ou l'un quelconque de leurs mélanges.

9. Procédé selon l'une des revendications 2 à 8, tel qu'une couche mince absorbant au moins partiellement le rayonnement laser est une couche constituée d'un métal, d'un oxyde métallique sous-stoechiométrique en oxygène ou d'un nitrure métallique.

10. Procédé selon l'une des revendications 2 à 9, tel qu'une couche mince absorbant au moins partiellement le rayonnement laser est une couche d'un oxyde métallique sous-stoechiométrique en oxygène, située sous et de préférence en contact avec la ou chaque couche d'argent ou située sur et de préférence en contact avec la ou chaque couche d'argent.

11. Procédé selon l'une des revendications 2 à 10, tel qu'une couche mince absorbant au moins partiellement le rayonnement laser est une couche à base de carbone, notamment du type graphite ou amorphe, en contact avec l'air.

12. Procédé selon l'une des revendications 2 à 11, tel qu'une couche mince absorbant au moins partiellement le rayonnement laser est une couche d'oxyde d'indium et d'au moins un élément choisi parmi l'étain et le zinc, qui est notamment la dernière couche de l'empilement.

13. Procédé selon l'une des revendications précédentes, tel que la puissance surfacique du rayonnement laser au niveau de l'empilement est supérieure ou égale à 1 kW/cm², notamment 20 kW/cm².

14. Procédé selon l'une des revendications précédentes, tel que le rayonnement laser est issu d'au moins un faisceau laser formant une ligne qui irradie simultanément toute ou partie de la largeur du substrat.

15. Procédé selon la revendication précédente, dans lequel on met en oeuvre un déplacement relatif entre le substrat revêtu de la couche et la ou chaque ligne laser, de sorte que la différence entre les vitesses respectives du substrat et du laser soit supérieure ou égale à 4 mètres par minute, notamment 6 mètres par minute.

16. Procédé selon l'une des revendications précédentes, tel que la longueur d'ondes du rayonnement laser est comprise entre 530 et 1000 nm.

17. Procédé selon l'une des revendications précédentes, tel que l'empilement est déposé par pulvérisation cathodique assistée par champ magnétique.

## Patentansprüche

1. Verfahren zur Herstellung einer OLED-Vorrichtung, die mindestens eine Elektrode auf der Basis eines Stapels aus elektrisch leitfähigen dünnen Schichten umfasst, der auf ein Substrat aufgebracht ist, wobei das Aufbringen des Stapels die folgenden Schritte umfasst:
- Aufbringen eines Stapels aus dünnen Schichten, der mindestens eine dünne Silberschicht zwischen mindestens zwei dünnen Schichten umfasst, auf eine Seite des Substrats,
- Wärmebehandeln der beschichteten Seite mithilfe mindestens einer Laserstrahlung, die in mindestens einer Wellenlänge zwischen 500 und 2000 nm emittiert, so dass der Flächenwiderstand des Stapels um mindestens 5 % verringert wird.

2. Verfahren nach Anspruch 1, wobei der Stapel vor der Behandlung mindestens eine dünne Schicht umfasst, welche die Laserstrahlung mindestens teilweise absorbiert, so dass die Absorption des Stapels bei mindestens einer Wellenlänge der Laserstrahlung derart ist, dass die Absorption eines Klarglassubstrats von 4 mm Dicke, das mit dem Stapel beschichtet ist, bei der mindestens einen Wellenlänge der Laserstrahlung größer als oder gleich 10 % ist.

3. Verfahren nach einem der vorhergehenden Ansprüche, wobei die Temperatur der Seite des Substrats, die der mit der mindestens einen Laserstrahlung behandelten Seite entgegengesetzt ist, während der Wärmebehandlung 100 °C, insbesondere 50 °C und sogar 30 °C nicht übersteigt.

4. Verfahren nach einem der vorhergehenden Ansprüche, wobei der Flächenwiderstand des Stapels durch die Wärmebehandlung um mindestens 15 % oder 20 % verringert wird.

5. Verfahren nach einem der vorhergehenden Ansprüche, wobei das Substrat aus Glas oder aus organischem Polymermaterial besteht.

6. Verfahren nach dem vorhergehenden Anspruch, wobei das Substrat aus Polyethylenterephthalat oder aus Polyethylennaphthalat besteht.

7. Verfahren nach einem der Ansprüche 2 bis 6, wobei eine dünne Schicht, die die Laserstrahlung mindestens teilweise absorbiert, eine Metallschicht ist, die direkt über der Silberschicht oder direkt unter der Silberschicht aufgebracht wird und deren Dicke zwischen 2 und 5 nm, insbesondere zwischen 3 und 5 nm, beträgt, wobei die Metallschicht insbesondere aus den Schichten auf der Basis von Titan, Nickel, Chrom, Niob oder einer beliebigen ihrer Legierungen gewählt wird.

8. Verfahren nach einem der Ansprüche 2 bis 7, wobei eine dünne Schicht, die die Laserstrahlung mindestens teilweise absorbiert, eine Nitridschicht ist, die insbesondere aus dem stöchiometrischen Nitrid von Titan oder den an Stickstoff unterstöchiometrischen Nitriden, von Silizium, Aluminium, Niob, Titan oder einem beliebigen ihrer Gemische gewählt wird.

9. Verfahren nach einem der Ansprüche 2 bis 8, wobei eine dünne Schicht, die die Laserstrahlung mindestens teilweise absorbiert, eine Schicht ist, die von einem Metall, einem an Sauerstoff unterstöchiometrischen Metalloxid oder einem Metallnitrid gebildet ist.

10. Verfahren nach einem der Ansprüche 2 bis 9, wobei eine dünne Schicht, die die Laserstrahlung mindestens teilweise absorbiert, eine an Sauerstoff unterstöchiometrische Metalloxidschicht ist, die sich unter und bevorzugt in Kontakt mit der oder jeder Silberschicht befindet oder sich auf und bevorzugt in Kontakt mit der oder jeder Silberschicht befindet.

11. Verfahren nach einem der Ansprüche 2 bis 10, wobei eine dünne Schicht, die die Laserstrahlung mindestens teilweise absorbiert, eine Schicht auf der Basis von Kohlenstoff, insbesondere graphitartig oder amorph, in Kontakt mit der Luft ist.

12. Verfahren nach einem der Ansprüche 2 bis 11, wobei eine dünne Schicht, die die Laserstrahlung mindestens teilweise absorbiert, eine Schicht aus Indiumoxid und mindestens einem Element, das unter Zinn und Zink gewählt wird, ist, die insbesondere die letzte Schicht des Stapels ist.

13. Verfahren nach einem der vorhergehenden Ansprüche, wobei die Flächenleistung der Laserstrahlung auf Ebene des Stapels größer als oder gleich 1 kW/cm², insbesondere 20 kW/cm², ist.

14. Verfahren nach einem der vorhergehenden Ansprüche, wobei die Laserstrahlung aus mindestens einem Laserstrahl stammt, der eine Linie bildet, die die gesamte Breite des Substrats oder einen Teil davon gleichzeitig bestrahlt.

15. Verfahren nach dem vorhergehenden Anspruch, wobei eine relative Verlagerung zwischen dem mit der Schicht beschichteten Substrat und der oder jeder Laserlinie ausgeführt wird, so dass die Differenz zwischen den jeweiligen Geschwindigkeiten des Substrats und des Lasers größer als oder gleich 4 Meter pro Minute, insbesondere 6 Meter pro Minute, ist.

16. Verfahren nach einem der vorhergehenden Ansprüche, wobei die Wellenlänge der Laserstrahlung zwischen 530 und 1000 nm beträgt.

17. Verfahren nach einem der vorhergehenden Ansprüche, wobei der Stapel durch magnetfeldgestütztes Sputtern aufgebracht wird.

## Claims

1. A process for manufacturing an organic light-emitting diode device comprising at least one electrode based on an electrically conductive thin-film multilayer deposited on a substrate, in which the deposition of said multilayer comprises the following steps:
- a thin-film multilayer comprising at least one thin silver film between at least two thin films is deposited on one face of said substrate; and
- the coated face is heat treated using at least one source of laser radiation emitted at at least one wavelength lying between 500 and 2000 nm so that the sheet resistance of the multilayer decreases by at least 5%.

2. The process as claimed in claim 1, such that said multilayer before treatment comprises at least one thin film at least partially absorbing the laser radiation so that the absorption of said multilayer at at least one wavelength of the laser radiation is such that the absorption of a clear glass substrate 4 mm in thickness coated with said multilayer at said at least one wavelength of the laser radiation is greater than or equal to 10%.

3. The process as claimed in either one of the preceding claims, such that the temperature of the face of the substrate opposite the face treated by the at least one source of laser radiation does not exceed 100°C, especially 50°C and even 30°C during the heat treatment.

4. The process as claimed in one of the preceding claims, such that the sheet resistance of the multilayer is decreased by at least 15% or 20% by the heat treatment.

5. The process as claimed in one of the preceding claims, such that the substrate is made of glass or a polymeric organic substance.

6. The process as claimed in the preceding claim, such that the substrate is made of polyethylene terephthalate or of polyethylene naphthalate.

7. The process as claimed in one of claims 2 to 6, such that a thin film at least partially absorbing the laser radiation is a metallic film deposited directly on top of the silver film or directly beneath the silver film and the thickness of which is between 2 and 5 nm, especially between 3 and 5 nm, this metallic film especially being chosen from films based on titanium, nickel, chromium, niobium, or any of their alloys.

8. The process as claimed in one of claims 2 to 7, such that a thin film at least partially absorbing the laser radiation is a nitride film, especially chosen from stoichiometric titanium nitride, or nitrogen-substoichiometric silicon, aluminum, niobium or titanium nitrides, or any of their mixtures.

9. The process as claimed in one of claims 2 to 8, such that a thin film at least partially absorbing the laser radiation is a film made of a metal, an oxygen-substoichiometric metal oxide or a metal nitride.

10. The process as claimed in one of claims 2 to 9, such that a thin film at least partially absorbing the laser radiation is an oxygen-substoichiometric metal oxide, located beneath and preferably in contact with the or each silver film, or located on and preferably in contact with the or each silver film.

11. The process as claimed in one of claims 2 to 10, such that a thin film at least partially absorbing the laser radiation is a carbon-based film, especially a graphite or amorphous film, in contact with air.

12. The process as claimed in one of claims 2 to 11, such that a thin film at least partially absorbing the laser radiation is a film of indium oxide and at least one element chosen from tin and zinc, which is especially the last film of the multilayer.

13. The process as claimed in one of the preceding claims, such that the surface power of the laser radiation on the multilayer is greater than or equal to 1 kW/cm², especially 20 kW/cm².

14. The process as claimed in one of the preceding claims, such that the laser radiation is emitted by at least one laser beam forming a line which simultaneously irradiates all or part of the width of the substrate.

15. The process as claimed in the preceding claim, in which a relative movement is induced between the substrate coated with the film and the or each laser line, so that the difference between the respective speeds of the substrate and the laser is greater than or equal to 4 meters per minute, especially 6 meters per minute.

16. The process as claimed in one of the preceding claims, such that the wavelength of the laser radiation is between 530 and 1000 nm.

17. The process as claimed in one of the preceding claims, such that the multilayer is deposited by magnetron sputtering.
